# EUROPEAN PATENT APPLICATION

(11) **EP 1 643 811 A1**
(43) Date of publication of application: **05.04.2006**
(21) Application number: 04734117.7
(22) Date of filing: 20.05.2004
(51) Int. Cl.: H05B 33/22

(54) **ORGANIC ELECTROLUMINESCENT DISPLAY PANEL**

(30) Priority: 21.05.2003 JP 2003143213
(71) Applicant: Pioneer Corporation, Tokyo 153-8654 (JP)
(72) Inventor: MIYAKE, Takako, c/o Corp. Research and Dev. Lab., Tsurugashima-shi, Saitama 350-2288 (JP)
(74) Representative: Manitz, Finsterwald & Partner GbR
(86) International application number: PCT/JP2004/007207
(87) International publication number: WO 2004/107821

(57) **Abstract**

Disclosed is an organic electroluminescent display panel which may be of passive-matrix type or active matrix type. When the organic electroluminescent display panel is of passive-matrix type, an organic functional layer is held between a first electrode line and a second electrode line. The organic functional layer contains a material with electroluminescent characteristics, and is arranged in a light-emitting region of the first electrode line. The light-emitting region is defined by an insulation layer having a window, and the insulation layer includes a gas barrier layer covering the peripheral portion of the windows. A partition wall and the organic functional layer may be sealed with a protection layer composed of an inorganic material. The partition wall may be formed in a region of the insulation layer where the window is not provided.

## Description

### Technical Field

The present invention relates to an organic electroluminescence (hereinafter referred to as an organic EL) display panel and a method of manufacturing the organic EL display panel.

### Background Art

An organic EL element is known in the art which includes an organic light-emitting material having luminescent characteristic. The organic EL element includes a transparent electrode, an organic functional layer having an organic light-emitting material, and a metal electrode, which are sequentially laminated on a transparent substrate.

There is, for example, an organic EL display panel having the organic EL elements which are arranged in a matrix pattern. Application of a flexible display panel is proposed for the organic EL display panel, in which a flexible substrate is made of, for example, a resin material. Since the flexible display panel has light weight and flexible properties as compared with the display panel having a glass substrate, the flexible display panel has less limitations in terms of the installation place.

The resin material, however, has a poor blocking characteristic against passage of moisture and gases such as oxygen. Specifically, the resin material has a poor gas barrier characteristic. Therefore, the moisture and gases may pass through the flexible substrate. If the moisture and gases come into contact with the organic functional layer, a light-emitting-function of the layer may deteriorate which produces light-emission disabled regions, i.e., so-called dark spots.

In order to prevent this deterioration in the flexible substrate, a gas barrier layer is proposed. The gas barrier layer is made of silicon nitride oxide, and is deposited on a resin base material (for example, Akira Sugimoto, "Development of organic EL film display," Optronics, Vol.3, 2001, pp.122-126).

Forming the gas barrier layer on the substrate imparts gas barrier characteristic to the flexible substrate. However, if a minute defect such as a pinhole is formed during the deposition of the gas barrier layer, moisture may pass through the substrate via such defect. Accordingly, the dark spot cannot be completely eliminated.

The problems to be solved by the present invention includes the above-described problem.

### Disclosure of Invention

According to one aspect of the present invention, an organic electroluminescence display panel is provided which includes a plurality of electrode line groups arranged in parallel to each other, an insulation layer having a plurality of windows arranged along electrode lines of the first electrode line groups so at to define light-emitting areas, and an organic functional layer formed in the light-emitting areas. The insulation layer includes a gas barrier layer which covers peripheries of the windows. The display panel may also include a plurality of second electrode line groups arranged to cross the first electrode lines via the organic functional layer.

Since intrusion of moisture into the organic functional layer from the surrounding of the display panel is blocked by the gas barrier layer, the display panel having the organic functional layer causing no deterioration can be obtained.

### Brief Description of Drawings

Figure 1 is a top view showing an embodiment of an organic EL display panel of the present invention;
Figure 2 is an enlarged fragmentary sectional view taken along line II - II of Figure 1;
Figure 2A is an enlarged fragmentary sectional view showing a modified embodiment of the organic EL display panel of the present invention;
Figure 3 is a top view showing another modified embodiment of the organic EL display panel of the present invention;
Figure 4 is an enlarged fragmentary sectional view taken along line IV-IV of Figure 3;
Figure 4A is an enlarged fragmentary sectional view similar to Figure 4, and illustrates a modified embodiment of the present invention;
Figure 5 is an enlarged fragmentary sectional view showing yet another modified embodiment of the organic EL display panel of the present invention;
Figures 6 to 12 are top views showing a series of manufacturing steps of the organic EL display panel according to the present invention;
Figure 13A is a cross-sectional view showing a organic functional layer formation process for the organic EL display panel of the present invention;
Figure 13B is a cross-sectional view showing another organic functional layer formation process of the organic EL display panel;
Figure 13C is a cross-sectional view showing yet another organic functional layer formation process the organic EL display panel;
Figure 14 is a top view showing a modified embodiment of a gas barrier layer formation process of the organic EL display panel of the present invention; and
Figure 15 is a top view showing another modified embodiment of a gas barrier layer formation process of the organic EL display panel of the present invention.

### Detailed Description of the Invention

An embodiment of an organic EL display panel according to the present invention will be described in detail with reference to the accompanying drawings. It should be noted that similar reference numerals and symbols are assigned to similar elements. Although the organic EL display panel includes a wiring, a driving section necessary for driving the display panel and so on, these devices are omitted from the following description.

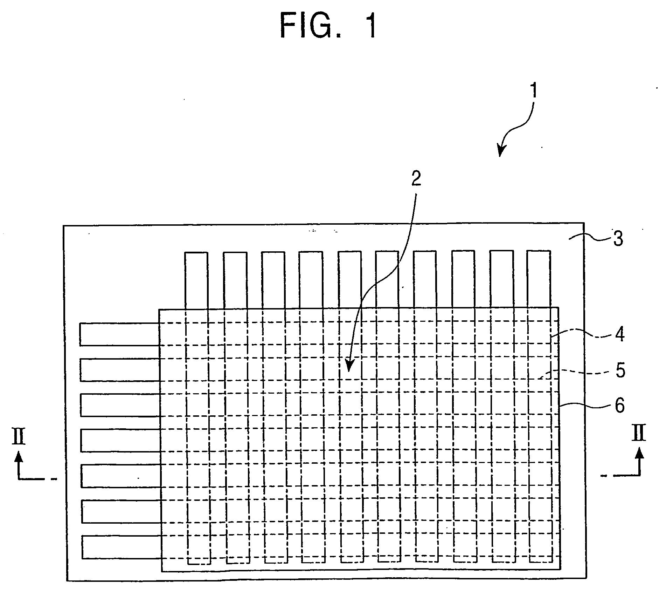

As shown in Figure 1, the organic EL display panel 1 according to this embodiment includes a display area 2 having a plurality of light-emitting sections (not shown) arranged in a matrix pattern. The light-emitting sections are formed of anode lines 4 as first electrodes, an organic functional layer (not shown) including a light-emitting layer having electroluminescence characteristic, and cathode lines 5 as second electrodes, which are sequentially laminated on a substrate 3. The display area 2 is covered with a protection layer 6.

The display area 2 includes light-emitting pixels (not shown) each consisting of three light-emitting sections which respectively emit, for example, red light, green light and blue light. It should be noted that instead of the light-emitting sections of red, green and blue colors, the display panel may be a monochrome display panel in which all the light-emitting sections are monochrome.

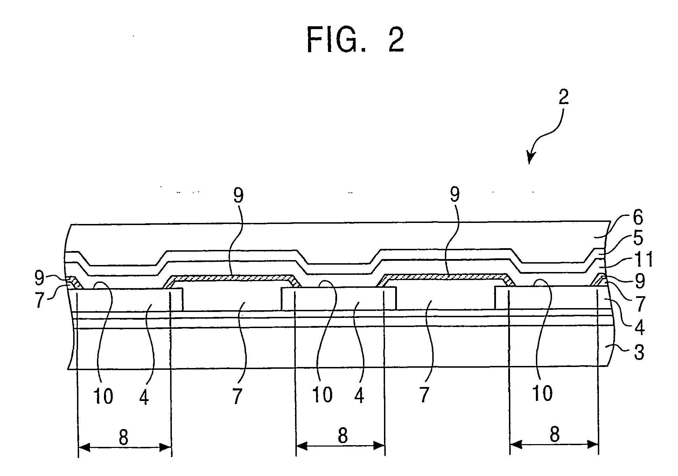

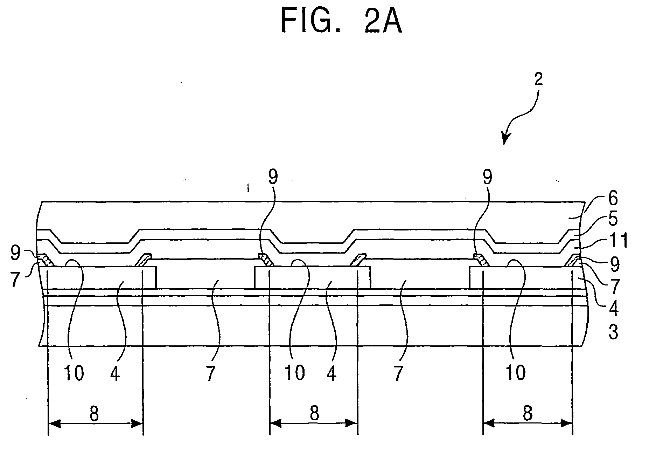

As shown in Figure 2, a plurality of anode lines 4 made of transparent material such as ITO (Indium Tin Oxide) are formed within the display area 2 on the substrate 3 having a light transparency characteristic and a gas barrier characteristic such as glass or resin. The anode lines 4 are arranged in parallel to each other. On the anode lines 4, an organic insulation layer 7 is formed which is made of an organic material having an insulation characteristic such as polyimide. The organic insulation layer 7 has windows 8 for exposing the anode lines 4.

The organic insulation layer 7 is covered with a gas barrier layer 9. It is preferable that the gas barrier layer 9 has an excellent insulation characteristic as well as an excellent gas barrier characteristic. It is also preferable that the gas barrier layer is made of a material that allows easy formation of a fine pattern. The material which can provide the above characteristic are, for example, an inorganic material such as silicon oxide, silicon nitride, or silicon nitride oxide. At least peripheries of the windows 8 are covered with the gas barrier layer 9 so as to define light-emitting areas 10 of the light-emitting sections. Specifically, in the embodiment of Figure 2, although the gas barrier layer 9 is formed in such a manner as to connect the peripheries of the adjacent windows 8, it is sufficient to form the gas barrier layer 9 only at the periphery of each window 8 as shown in Figure 2A.

In the light-emitting areas 10, the organic functional layer 11 including light-emitting layer is formed. The light-emitting layer is made of an organic compound exhibiting an electroluminescence characteristic. The organic functional layer 11 is in contact with the anode lines 4 in the light-emitting areas 10. It should be noted that the organic functional layer 11 may have a laminated structure including, for example, a functional layer. The functional layer improves a current injection efficiency when a current is injected into the light-emitting layer.

The cathode lines 5 are provided to cross the anode lines 4 via the organic functional layer 11. The cathode lines 5 are made of a metal having a low electrical resistance such as A1 alloy. The organic functional layer 11 and the cathode lines 5 are sealed with the protection layer 6 made of an inorganic material having a gas barrier characteristic such as silicon nitride.

As described above, in the organic EL display panel, the anode lines or the gas barrier layer, which are both made of an inorganic material, is formed between the organic functional layer and the substrate. The inorganic material has a blocking characteristic as compared with the organic material against the passage of gases such as gases including organic substances and moisture. Accordingly, even though gases such as oxygen and moisture may pass through the substrate 3 from the surrounding air of the panel, they cannot pass through the anode lines 4 and the gas barrier 9. Therefore, the organic functional layer 11 can be protected from these gases.

As an alternate embodiment, the display area of the organic EL display panel may include ramparts (i.e., partition walls) which define a light-emitting pattern.

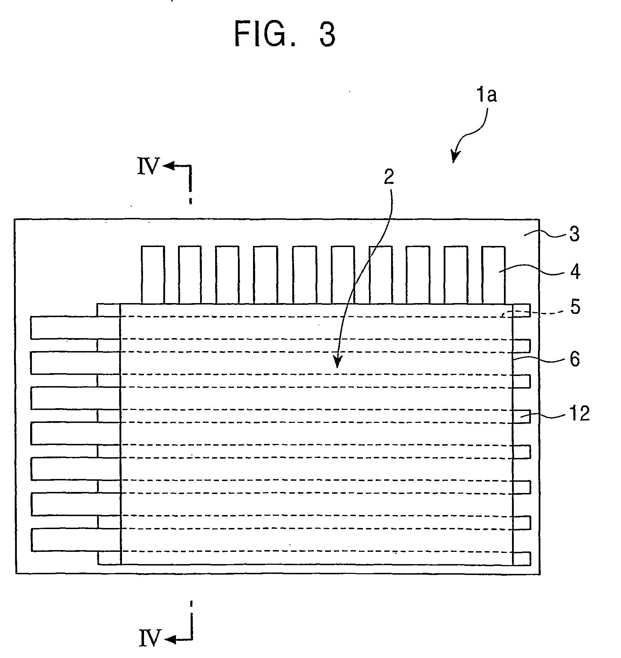

For example, as shown in Figure 3, within the display area 2 of an organic EL display panel 1a, the anode lines 4, the organic functional layer (not shown) including the light-emitting layer, and the cathode lines 5 are sequentially laminated. The ramparts 12 are provided between the cathode lines 5 so as to separate the cathode lines 5 from each other. The cathode lines 5 and the ramparts 12 are partly covered with the protection layer 6. It should be noted that above description of Figure 3 has been made based on a plurality of ramparts 12, however, since all ramparts 12 shown in Figure 3 are formed on the same plane, these ramparts 12, as a whole, may be referred to as a single rampart layer. Specifically, the rampart layer includes a plurality of ramparts (rampart elements).

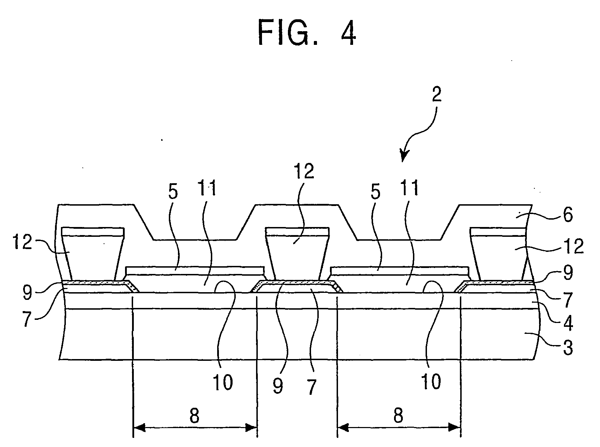

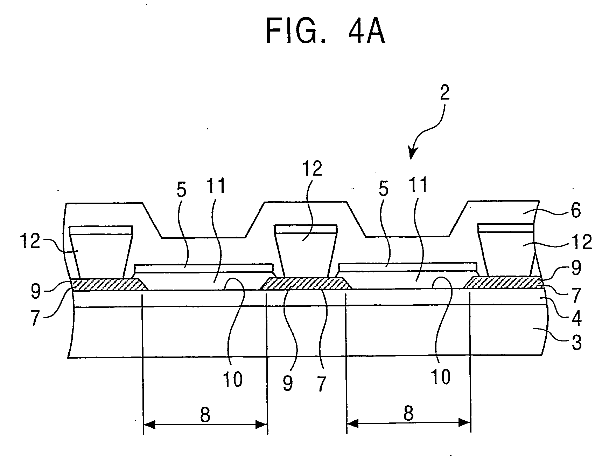

As shown in Figure 4, for example, a plurality of anode lines 4 made of transparent material such as ITO are formed in the display area 2 on the substrate 3 made of resin. The anode lines 4 are arranged in parallel to each other. On the anode lines 4, the windows 8 are formed of the organic insulation layer 7 made of an organic material having an insulation characteristic such as polyimide.

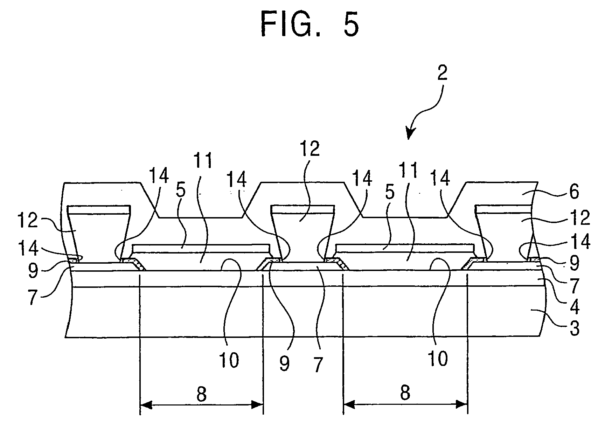

The organic insulation layer 7 is covered with the gas barrier layer 9. At least peripheries of the windows 8 are covered with the gas barrier layer 9 so as to define light-emitting areas 10 of the light-emitting sections. Specifically, although the gas barrier layer 9 is formed in such a manner as to connect the peripheries of the adjacent windows 8 in Figure 4, it is sufficient to form the gas barrier layer 9 only at the periphery of each window 8 as shown in Figure 5.

In regions of the gas barrier layer 9 other than the windows 8, the linear-shaped ramparts 12 are provided so as to perpendicularly cross the anode lines 4. The ramparts 12 are formed so as to protrude from the gas barrier layer 9. The ramparts 12 may be formed, for example, by firstly providing a photoresist on the substrate, and then carrying out an exposure process using a mask followed by a development process. The ramparts 12 are formed to have a cross section of, for example, inverse truncated triangle shapes, and are arranged in parallel to each other.

In the light-emitting areas 10, the organic functional layer 11 including the light-emitting layer is formed. The organic functional layer 11 is in contact with the anode lines 4 in the light-emitting areas 10. Since the light-emitting areas 10 are defined by the gas barrier layer 9, the organic functional layer 11 is not in contact with the organic insulation layer 7.

On the organic functional layer 11, the cathode lines 5 are formed which are made of a metal having a low electrical resistance such as A1 alloy. The cathode lines 5 are electrically separated from each other by the ramparts 12.

The organic functional layer 11, the cathode lines 5, and the ramparts 12 are sealed with the protection layer 6 which is made of an inorganic material having a gas barrier characteristic such as silicon nitride.

In the above-described organic EL panel, diffusion of moisture coming from the outside of the panel can be blocked by the gas barrier layer thereby preventing formation of the dark spots. Furthermore, deterioration caused by an internal factor, particularly, deterioration inherent in the display panel provided with the ramparts, can be prevented.

The internal factor includes the gases such as moisture or organic compounds which are released from the ramparts when the organic EL display panel provided with the ramparts becomes high temperature. These gases are generated by a heat-up of a water and/or an organic solvent, which are included in the photoresist used for the rampart material, and which remain in the ramparts.

In the above-described organic EL panel, diffusion of these gases released from the ramparts is blocked by the gas barrier layer. Accordingly, a deterioration caused by the contact between these gases and the organic functional layer can be prevented.

The ramparts 12 are sealed with the gas barrier layer 9 and the protection layer 6 which are both made of inorganic materials, and therefore the gases generated in the ramparts 12 cannot diffuse therefrom. Consequently, these gases are trapped in the ramparts 12. Since these gases do not intrude into the organic functional layer 11, deterioration caused by these gases, i.e., dark spots, can be prevented.

Note that the gas barrier layer may not be provided between the rampart and organic insulation layer. Such structure (alternative embodiment) will be hereinafter described. For example, as shown in Figure 5, the gas barrier layer 9 includes openings 14 at the positions of the ramparts 12. Within the openings 14, the ramparts 12 are in contact with the organic insulation layer 7. Other than the structure described above, the structures of the panel shown in Figure 5 are similar to those of the embodiment shown in Figure 4.

In the organic EL display panel having the structure described above, the ramparts are provided on the organic insulation layer made of the organic substance. Accordingly, adhesiveness between the ramparts and the organic insulation layer is improved. Since it is difficult to remove the ramparts from the substrate, damages of the panel caused by the separation of the ramparts do not occur.

Furthermore, since the gas barrier layer is formed between the organic functional layer and the organic insulation layer, those gases which intrude into the organic insulation layer from the ramparts cannot pass through the gas barrier layer thereby preventing the diffusion to the organic functional layer. Accordingly, deterioration caused by the internal factor can be prevented.

It should be noted that the display area may be sealed with a can sealing which has a hollow portion and includes an adsorbent in the hollow portion. Application of the can sealing may omit the protection layer.

The substrate may also be flexible, which is made of, for example, film resin.

A method of manufacturing the above-described organic EL display panel will be hereinafter described.

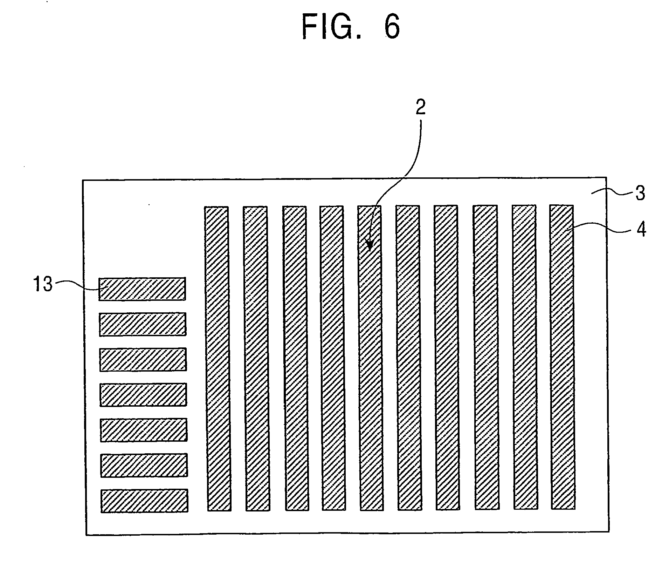

As shown in Figure 6, an anode formation process is carried out to form a plurality of anode lines 4 so as to extend parallel to each other on the substrate 3 . In the anode formation process, island-shaped pads 13 are also formed which will be connected to the cathode lines.

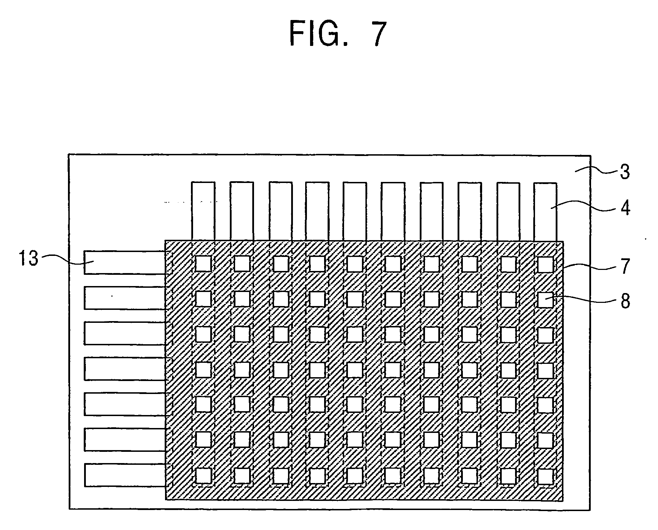

After the anode formation process, as shown in Figure 7, an organic insulation layer formation process is carried out in which the organic insulation layer 7 is formed by means of a photo-lithograph method. The organic insulation layer 7 has a plurality of windows 8 which are arranged along the anode lines 4. The organic insulation layer forming process includes a process to deposit a photosensitive resin such as polyimide by means of a deposition method such as spin coating. It is preferable that an organic insulation material used for the organic insulation layer has sufficient coating property when applied on a stepped section.

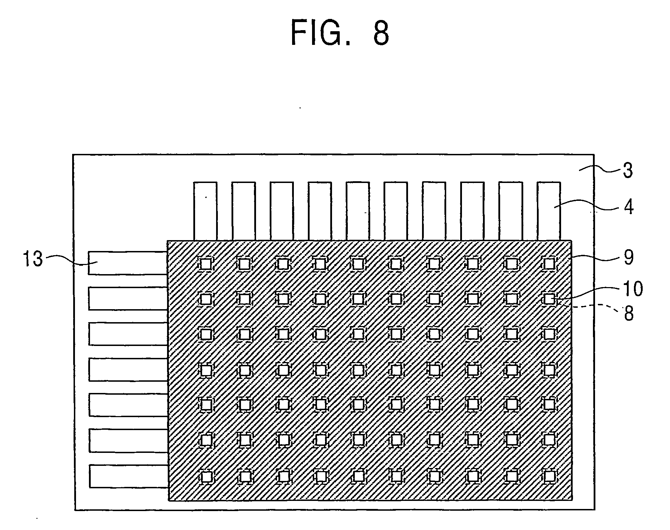

As shown in Figure 8, after forming the organic insulation layer, a gas barrier layer formation process is carried out in which the gas barrier layer 9 made of inorganic material having an insulation property such as silicon nitride oxide is formed by means of the sputtering method. The gas barrier layer formation process includes a mask formation step by means of a resist on the inorganic material layer which is formed by the sputtering. The mask corresponds to a pattern of the light-emitting areas. The gas barrier layer formation process further includes etching step by means of a plasma etching method. Upon performing the above steps, a pattern of the light-emitting areas 10 is formed. It should be noted that the light-emitting areas 10 are formed by covering at least peripheries of the windows 8 with the gas barrier layer 9.

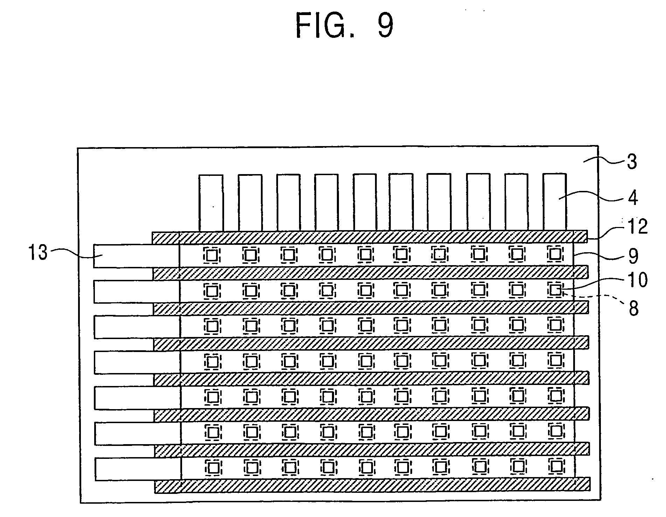

As shown in Figure 9, after applying a photosensitive resin such as polyimide on the display area having the gas barrier layer formed thereon, a rampart formation process is carried out in which the ramparts 12 are formed by means of an exposure process using a photomask and a development process. The ramparts 12 are formed so as to expose the light-emitting areas 10. The ramparts 12 protrude from the substrate 3 so that a recessed portion is defined between each two adjacent ramparts 12.

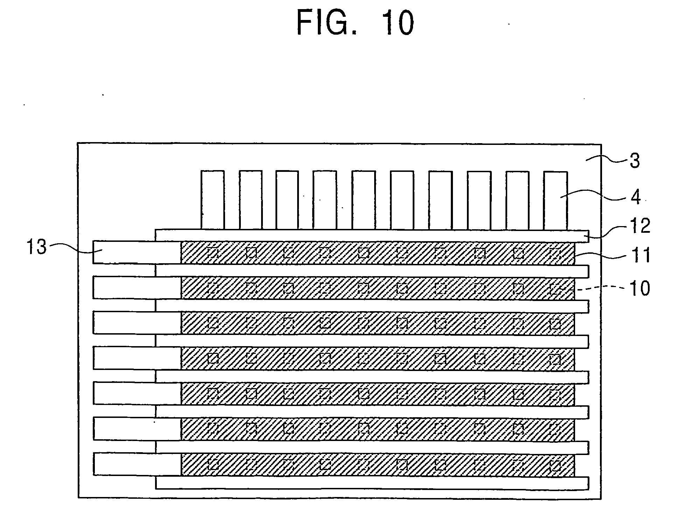

After the rampart formation process, as shown in Figure 10, the organic functional layers 11 are formed by means of a deposition method such as a mask evaporation method. The organic functional layers 11 are formed in regions other than the locations of the ramparts 12. The organic functional layers 11 are formed to be in contact with the anode lines 4 at the light-emitting areas 10. It should be noted that since all of the plurality of organic functional layers described above are formed on the same plane, these organic functional layers, as a whole, may be referred to as a single organic functional layer.

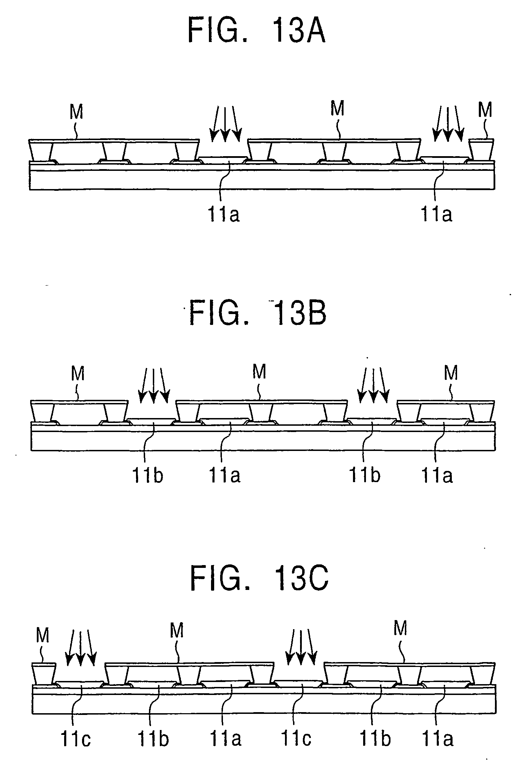

The organic functional layers are formed, as shown for example in Figures 13A, by aligning openings of the deposition mask M with recessed portions on the substrate having the ramparts 12 formed thereon. Then, the mask M is placed on the ramparts. Thereafter, first organic functional layers 11a, for example, red color, are formed so as to have a predetermined thickness by means of the evaporation method. After the formation of the first organic functional layers 11a, the deposition mask M is displaced toward the next rampart on the left side and alignment is carried out. Thereafter, the deposition mask M is placed on the ramparts, and second organic functional layers 11b, for example, green color, are formed (Figure 13B). The deposition mask M are aligned with the unprocessed recessed portions. Then the deposition mask M is placed on the ramparts. Thereafter, third organic functional layers 11c, for example, blue color, are formed (Figure 13C). Upon performing the above steps, the organic functional layers 11 are formed in the display area as shown in Figure 10.

Alternatively, the organic functional layers may be formed by a single deposition process applied on the whole display area without using the deposition mask. Because of the height of the ramparts, isolation of the deposited substances between the rampart sections and the sections other than the locations of the ramparts is made by this deposition method. Accordingly, the organic functional layers formed in the sections other than the locations of the ramparts are defined by the ramparts. Specifically, a pattern of the organic functional layer is formed by the ramparts.

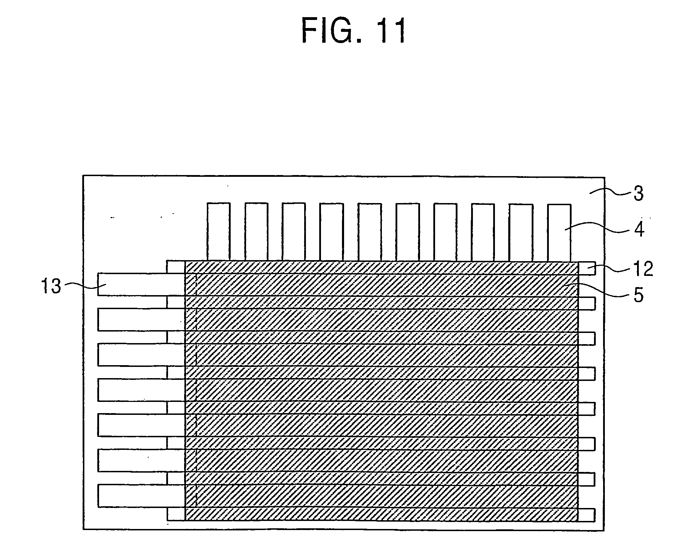

After the formation of the organic functional layers, as shown in Figure 11, a cathode formation process is carried out in which the cathode lines 5 are formed in the display area by means of a deposition of an inorganic substance having low electrical resistance such as Al alloy. The deposition is carried out by using an anisotropic flow of the inorganic material. The cathode lines 5 are defined by the ramparts 12. Specifically, the cathode lines 5 are separated from each other because of the height of the ramparts 12. It should be noted that the cathode lines 5 are formed to electrically connect to the cathode connecting pads 13 during the deposition.

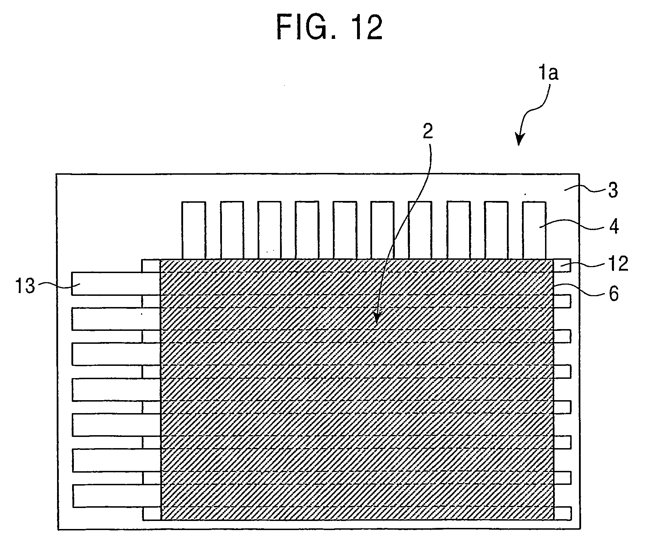

As shown in Figure 12, the display area 2 provided with the cathode lines 5 is sealed with the protection layer 6 made of inorganic material having a gas barrier characteristic such as silicon nitride. The sealing is carried out by means of a deposition method such as a plasma CVD (Chemical Vapor Deposition) method. It is preferable that the protection layer material is isotropically applied by the deposition method of the protection layer 6.

Upon performing the above-described processes, the organic EL display panel 1a shown in Figure 3 is formed.

It should be noted that when the organic insulation layer is formed to have sloped surfaces in order to cover stepped sections at ends of the anode lines in the above manufacturing method, the deposition material can be deposited on the sloped surfaces , even though a deposition method using an anisotropic flow of the deposited material is applied for the formation of the organic functional layer and the cathode lines. Consequently, no disconnection of the organic functional layer and the cathode line occurs between the light-emitting areas thereby improving reliability of the display panel.

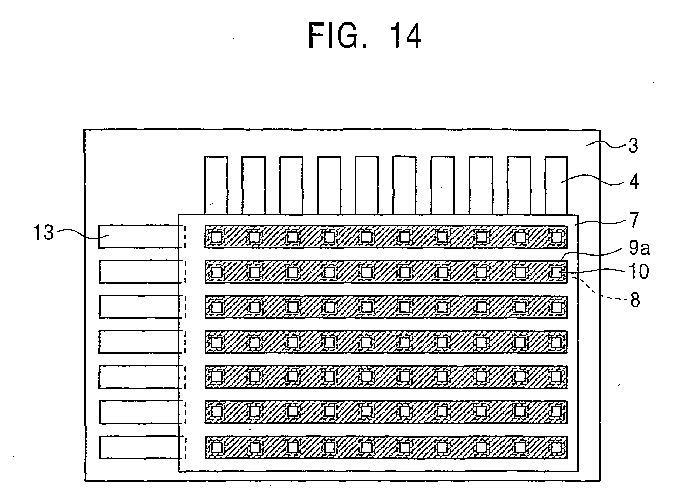

The method of manufacturing the organic EL display panel having the structure shown in Figure 5 is similar to that of the above-described embodiment except for the gas barrier layer formation process. In the gas barrier layer formation process, as shown for example in Figure 14, band-shaped gas barrier layers 9a are formed on the organic insulation layer 7. The gas barrier layers 9a extend to a direction perpendicular to the anode lines, and cover the peripheries of the windows 8. After the gas barrier layer formation process, the ramparts are formed between the gas barrier layers such that the ramparts 12 are in contact with the organic insulation layer. It should be noted that since all of the plurality of gas barrier layers 9a mentioned above are formed on the same plane, these gas barrier layers 9a, as a whole, may be referred to as a single gas barrier layer having a plurality of gas barrier elements.

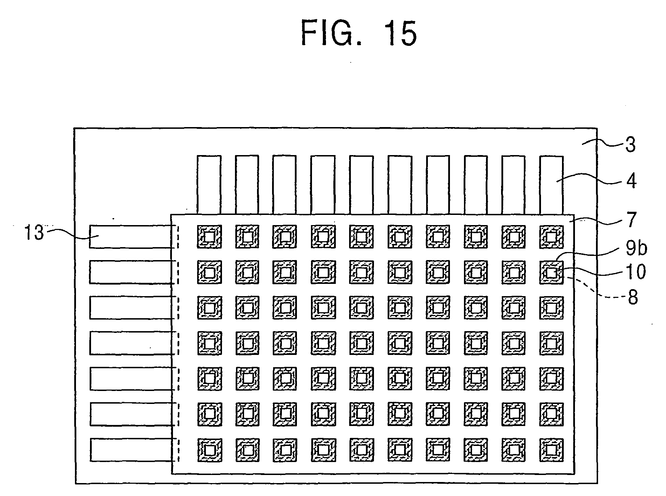

As an alternative embodiment, as shown in Figure 15, the gas barrier layer formation process may provide island-shaped gas barrier layers 9b which cover only the peripheries of the windows 8 of the organic insulation layer 7. It should be noted that since all of the plurality of gas barrier layers 9b mentioned above are formed on the same plane, these gas barrier layers 9b, as a whole, may be referred to as a single gas barrier layer having a plurality of island-shaped gas barrier elements. After the gas barrier layer formation process, the rampart formation process and the organic functional layer forming process are carried out. In the rampart forming process, the ramparts are formed so as to extend in parallel to the island-shaped gas barrier layer lines perpendicular to the anode lines. The ramparts are formed at regions other than the locations where the windows are formed. In the organic functional layer formation process, the organic functional layers are formed only within the light-emitting areas. After forming the organic functional layers, the cathode formation process and the sealing process are carried out. In the cathode formation process, the cathode lines are formed by providing substance such as Al alloy in the display area. In the sealing process, the organic functional layers and the ramparts are sealed. Accordingly, the organic EL display panel is obtained.

The above embodiments deal with the display panel of a passive drive type. The present invention, however, is not limited to the passive drive type. Specifically, the present invention can be applied to the display panel of an active drive type.

In the above embodiments, the insulation layer defining the light-emitting areas includes the laminated layers having the organic insulation layer and the gas barrier layer. The present invention, however, is not limited to the laminated layers. Specifically, the insulation layer may be formed only by the gas barrier layer.

Furthermore, in the above embodiments, the anode electrodes and the cathode electrodes may be converted into one another. Specifically, the cathode lines, the organic functional layer, and the anode lines may be sequentially laminated on the substrate in the described order.

Further, as shown in Figure 4A, the insulation layer 7 itself may be formed to serve as the gas barrier layer 9, i.e. , the insulation layer is equal to the gas barrier layer.

This application is based on a Japanese patent application No. 2003-143213, the entire disclosure of which is incorporated herein by reference.

## Claims

1. An organic electroluminescence display panel comprising:
a plurality of electrode line groups arranged in parallel to each other;
an insulation layer having a plurality of windows for defining light-emitting areas, the windows being arranged along electrode lines of the electrode line groups; and
an organic functional layer formed in the light-emitting areas;
wherein the insulation layer includes a gas barrier layer which covers peripheries of the windows.

2. The organic electroluminescence display panel according to claim 1, wherein the gas barrier layer is made of an inorganic material.

3. The organic electroluminescence display panel according to claim 1, wherein the insulation layer is made of an inorganic material and organic material.

4. The organic electroluminescence display panel according to claim 1 further comprising a rampart layer that includes a rampart element so as to extend in regions other than the windows of the insulation layer.

5. The organic electroluminescence display panel according to claim 4, wherein the organic functional layer and the rampart layer are sealed with a protection layer having gas barrier property made of an inorganic material.

6. The organic electroluminescence display panel according to claim 1, wherein the gas barrier layer includes a plurality of band-shaped gas barrier elements that extend to a direction perpendicular to the electrode lines.

7. The organic electroluminescence display panel according to claim 1, wherein the gas barrier layer includes a plurality of island-shaped gas barrier elements.

8. The organic electroluminescence display panel according to claim 3, wherein the organic material is polyimide.

9. The organic electroluminescence display panel according to claim 1, wherein the insulation layer is formed only of the gas barrier layer.

10. The organic electroluminescence display panel according to claim 2, wherein the inorganic material is silicon oxide, silicon nitride or silicon nitride oxide.

11. The organic electroluminescence display panel according to claim 1, wherein the organic functional layer includes a functional layer which improves current injection efficiency when a current is injected into a light-emitting layer.

12. The organic electroluminescence display panel according to claim 4, wherein the rampart element protrude from the gas barrier layer.

13. The organic electroluminescence display panel according to claim 4, wherein the rampart element is formed to have a cross section of an inverse truncated triangle shape, and the rampart elements are arranged in parallel to each other.

14. The organic electroluminescence display panel according to claim 4, wherein the rampart element is formed on the insulation layer via the gas barrier layer.

15. The organic electroluminescence display panel according to claim 4, wherein the rampart element is in contact with the insulation layer.

16. The organic electroluminescence display panel according to claim 5, wherein the inorganic material is silicon nitride.

17. The organic electroluminescence display panel according to claim 1, wherein a substrate of the organic electroluminescence display panel is flexible.

18. The organic electroluminescence display panel according to claim 17, wherein the flexible substrate is made of film resin.

19. The organic electroluminescence display panel according to claim 1, wherein a display area of the organic electroluminescence display panel is sealed with a can sealing having a hollow structure and including an adsorbent in the hollow portion.

20. The organic electroluminescence display panel according to claim 1, wherein the insulation layer itself serves as the gas barrier layer.

21. A method of manufacturing an organic electroluminescence display panel comprising the steps of:
forming a plurality of electrode line groups so as to extend parallel to each other on a substrate;
forming an insulation layer so as to have a plurality of windows for defining light-emitting areas, the windows being arranged along electrode lines of the electrode line groups, and the insulator layer including a gas barrier layer covering peripheries of the windows; and
forming an organic functional layer in the light-emitting areas so as to contact with the electrode line groups.
